# EUROPÄISCHE PATENTSCHRIFT

(11) **EP 3 103 315 B1**
(45) Veröffentlichungstag und Bekanntmachung des Hinweises auf die Patenterteilung: **16.09.2020**
(21) Anmeldenummer: 14808630.9
(22) Anmeldetag: 08.12.2014
(51) Int. Cl.: H05K 5/00

(54) **ELEKTRISCHES GERÄT UND VERBINDUNGSANORDNUNG MIT EINEM ELEKTRISCHEN GERÄT**
ELECTRICAL DEVICE AND CONNECTION ARRANGEMENT HAVING AN ELECTRICAL DEVICE
APPAREIL ÉLECTRIQUE ET DISPOSITIF DE LIAISON COMPORTANT UN APPAREIL ÉLECTRIQUE

(30) Priorität: 07.02.2014 DE 102014202296
(43) Veröffentlichungstag der Anmeldung: 14.12.2016
(73) Patentinhaber: Robert Bosch GmbH, 70442 Stuttgart (DE)
(72) Erfinder: GUECKEL, Richard, 71701 Schwieberdingen (DE); KROECKEL, Markus, 71701 Schwieberdingen (DE)
(86) Internationale Anmeldenummer: PCT/EP2014/076808
(87) Internationale Veröffentlichungsnummer: WO 2015/117695

(56) Entgegenhaltungen:
- DE-A1-102004 060 302
- FR-A1- 2 979 518
- US-A1- 2004 095 732
- US-B1- 7 094 075

## Beschreibung

### Stand der Technik

Die Erfindung betrifft ein elektrisches Gerät, insbesondere ein Schalt- oder Steuergerät für ein Kraftfahrzeug, nach dem Oberbegriff des Anspruchs 1. Ferner betrifft die Erfindung eine Verbindungsanordnung zwischen einem erfindungsgemäßen elektrischen Gerät und einem Anschlussstecker.

Ein elektrisches Gerät nach dem Oberbegriff des Anspruchs 1 ist aus der DE 33 10 477 A1 der Anmelderin bekannt. Das bekannte elektrische Gerät dient innerhalb eines Kraftfahrzeugs beispielsweise als Steuergerät für eine Einspritzanlage und weist ein Gehäuse zur Aufnahme eines Schaltungsträgers in Form einer Leiterplatte auf. Die elektrische Kontaktierung des elektrischen Geräts erfolgt über einen Anschlussbereich des Gehäuses, der an einer Stirnseite des Gehäuses angeordnet ist. Hierzu ist eine Stirnseite des Gehäuses mittels eines Steckerkörpers verschlossen, der üblicherweise als Kunststoffspritzgussteil ausgebildet ist. Durch den Steckerkörper ragen Anschlusspins bzw. Anschlussfahnen hindurch, die einerseits mit dem Schaltungsträger innerhalb des Gehäuses, und andererseits mit einem fahrzeugseitigen Kabelbaumstecker, im Folgenden als Anschlußstecker bezeichnet, elektrisch kontaktierbar sind. Die Steckerpins sind innerhalb eines üblicherweise rechteckförmigen, umlaufenden und geschlossenen Wandbereichs des Steckerkörpers (Steckerkragen) angeordnet. Zur Kontaktierung des elektrischen Geräts mit dem Anschlußstecker umgreift der Anschlußstecker den Wandbereich (Steckerkragen) des Steckerkörpers an seinem Außenumfang, wobei durch eine entsprechende geometrische Dimensionierung des Anschlusssteckers eine Zentrierung des Anschlusssteckers am umlaufenden Wandbereich des Steckerkörpers stattfindet, damit die elektrische Kontaktierung der Anschlusspins mit entsprechenden Gegenelementen im Anschlussstecker problemlos erfolgt. Um den Anschlußstecker darüber hinaus mit dem elektrischen Gerät mechanisch fest zu verbinden bzw. zu verriegeln, weist das bekannte elektrische Gerät im Bereich seines Steckerkörpers außerhalb des Wandbereichs mehrere Rastnasen auf, die mit einer entsprechenden Gegenkontur am Anschlußstecker zusammenwirken. Weiterhin weist der Anschlußstecker beispielsweise einen Verschlusshebel auf, der mit den Rastnasen zusammenwirkt und in seiner Verriegelungsstellung eine klemm- bzw. kraftschlüssige Verbindung des Anschlusssteckers mit dem elektrischen Gerät erzeugt.

Eine Verbindungsanordnung zwischen einem elektrischen Gerät und einem (fahrzeugseitigen) Anschluss- bzw. Kabelbaumstecker, bei dem ein Fixier- bzw. Verriegelungselement (Rastnase an dem Steckerkörper) außerhalb des umlaufenden Wandbereichs der Aufnahmekontur am elektrischen Gerät angeordnet ist und zur Anwendung mit dem Anschlußstecker kommt, wird auch als Außenverriegelung bezeichnet. Eine Außenverriegelung ermöglicht insbesondere eine relativ gute Dichtheit zwischen der Aufnahmekontur und dem Anschlussstecker, die das Eindringen von Feuchtigkeit usw. erschwert bzw. verhindert, da der Anschlussstecker die Aufnahmekontur bzw. den Wandbereich von außen her umfasst. Nachteilig dabei ist, dass die Verbindungsanordnung durch den außerhalb des umlaufenden Wandbereichs angeordneten Anschlußstecker und dessen Verschlussmechanismus zwangsläufig eine relativ große Breite aufweist. Dies ist insbesondere bei beengten Einbauverhältnissen in Kraftfahrzeugen, bei denen beispielsweise die Höhe des elektrischen Geräts möglichst gering gewählt werden muss, problematisch.

Aus diesem Grund sind aus dem Stand der Technik auch Verbindungsanordnungen zwischen einem elektrischen Gerät und einem Anschlussstecker bekannt, bei denen die Fixier- bzw. Verriegelungselemente innerhalb der Aufnahmekontur bzw. des umlaufenden Wandbereichs des Anschlusssteckers angeordnet sind. Der (fahrzeugseitige) Anschlussstecker ist hierbei innerhalb der Aufnahmekontur des Steckerkörpers angeordnet, so dass in Bezug auf eine Gehäusehöhe des elektrischen Geräts (bzw. der Breite der Aufnahmekontur) besonders niedrige elektrische Geräte hergestellt werden können. Nachteilig dabei ist, dass eine derartige Anordnung der Fixier- bzw. Verriegelungselemente und des Anschlusssteckers, die eine sogenannte Innenverriegelung ausbilden, hinsichtlich der Dichtheit nicht die Dichtheit einer Außenverriegelung erreicht. Jedoch gibt es Anwendungsfälle, bei denen entweder aufgrund beengter Einbauverhältnisse, oder aufgrund nicht erforderlicher Dichtheitserfordernisse eine Innenverriegelung eingesetzt wird. Zusammengefasst sind daher Verbindungsanordnungen an elektrischen Geräten bekannt, die entweder dazu ausgebildet sind, eine Außenverriegelung oder eine Innenverriegelung auszubilden, wobei die Fixier- bzw. Verriegelungselemente hierzu entweder außerhalb der Aufnahmekontur oder innerhalb der Aufnahmekontur des Anschlussbereichs am elektrischen Gerät angeordnet sind.

Weitere Beispiele von Verbindungsanordnungen sind in DE102004060302, US7094075, FR2979518 und US2004095732 offenbart.

### Offenbarung der Erfindung

Ausgehend von dem dargestellten Stand der Technik liegt der Erfindung die Aufgabe zugrunde, ein elektrisches Gerät, insbesondere Schalt- oder Steuergerät in einem Kraftfahrzeug, nach dem Oberbegriff des Anspruchs 1 derart weiterzubilden, dass es universell sowohl zur Verwendung bzw. Ausbildung einer Außenverriegelung, als auch für eine Innenverriegelung einsetzbar ist. Mit anderen Worten gesagt bedeutet dies, dass ein und derselbe Anschlussbereich des Gehäuses des elektrischen Geräts mit unterschiedlichen (fahrzeugseitigen) Anschlusssteckern verwendbar sein soll.

Diese Aufgabe wird erfindungsgemäß bei einem elektrischen Gerät mit den Merkmalen des Anspruchs 1 dadurch gelöst, dass jeweils wenigstens ein Fixier- bzw. Verriegelungselement sowohl innerhalb als auch außerhalb des Wandbereichs des Anschlussbereichs des elektrischen Geräts angeordnet ist. Mit anderen Worten gesagt bedeutet dies, dass bei einem fahrzeugseitigen Anschlussstecker, der zur Ausbildung einer Außenverriegelung ausgebildet ist, das wenigstens eine Fixier- bzw. Verriegelungselement, das außerhalb des Wandbereichs angeordnet ist, mit dem Anschlussstecker zusammenwirkt, während bei einer Verwendung mit einem Anschlussstecker, der zur Ausbildung einer Innenverriegelung ausgebildet ist, das wenigstens eine innerhalb des Wandbereichs angeordnete Fixier- bzw. Verriegelungselement mit dem Anschlussstecker zusammenwirkt.

Vorteilhafte Weiterbildungen des erfindungsgemäßen elektrischen Geräts sind in den Unteransprüchen aufgeführt.

In besonders bevorzugter Ausgestaltung ist es vorgesehen, dass das wenigstens eine Fixier- bzw. Verriegelungselement unmittelbar an dem Wandbereich befestigt ist. Dadurch wird insbesondere eine besonders geringe Breite des Anschlussbereichs erzielt, da, im Gegensatz zum eingangs erwähnten Stand der Technik, das wenigstens eine Fixier- bzw. Verriegelungselement nicht beabstandet zu dem Wandbereich angeordnet ist. Zusätzlich lässt sich dadurch auch eine besonders gute Abdichtung zwischen dem Wandbereich und dem Anschlussstecker erzielen, da die erzeugten Klemm- bzw. Haltekräfte zwischen dem elektrischen Gerät und dem Anschlussstecker in unmittelbarer Nähe des Wandbereichs erzeugt werden.

In bevorzugter Weiterbildung des zuletzt gemachten Vorschlags ist es vorgesehen, dass das wenigstens eine Fixier- bzw. Verriegelungselement an dem Wandbereich einstückig angeformt ist. Mit anderen Worten gesagt bedeutet dies, dass das Gehäuse des elektrischen Geräts im Bereich des Anschlussbereichs insbesondere als Spritzgussteil ausgebildet ist, bei dem das wenigstens eine Fixier- bzw. Verriegelungselement bei der Fertigung des Anschlussbereichs gleich mit berücksichtigt werden kann, so dass im Gegensatz zu als separaten Bauteilen ausgebildeten Fixier- bzw. Verriegelungselementen der Fertigungsaufwand besonders niedrig ist.

In bevorzugter geometrischer Ausgestaltung der Aufnahmekontur ist diese im Wesentlichen rechteckförmig ausgebildet, wobei der Wandbereich wenigstens zwei zueinander parallele Wandabschnitte aufweist, und wobei an jedem der beiden parallelen Wandabschnitte jeweils wenigstens ein Fixier- bzw. Verriegelungselement angeordnet ist. Dadurch wird insbesondere eine über den Umfang der Aufnahmekontur gesehen gleichmäßige Anpresskraft des Anschlusssteckers an dem Gehäuse des elektrischen Geräts erzielt. Darüber hinaus wird erwähnt, dass bei einer Erhöhung der Anzahl der Fixier- bzw. Verriegelungselemente die je Fixier- bzw. Verriegelungselement zu übertragenden Kräfte reduziert werden können. Weiterhin erzeugt eine größere Anzahl von Fixier- bzw. Verriegelungselementen auch eine besonders gleichmäßige Verteilung der Anpresskraft des Anschlusssteckers an dem Gehäuse.

Zur Optimierung der Außenverriegelung bzw. Innenverriegelung kann es vorgesehen sein, dass das jeweils wenigstens eine Fixier- bzw. Verriegelungselement innerhalb und außerhalb des Wandbereichs unterschiedlich ausgebildet ist.

Konstruktiv lässt sich ein Fixier- bzw. Verriegelungselement besonders einfach ausbilden, wenn dieses eine Aussparung zur formschlüssigen Aufnahme eines Gegenelements des Anschlusssteckers aufweist.

Weiterhin ist es vorteilhaft, wenn das jeweils wenigstens eine Fixier- bzw. Verriegelungselement innerhalb und außerhalb des Wandbereichs auf unmittelbar gegenüberliegenden Bereichen des Wandbereichs angeordnet ist. Hintergrund hierfür ist, dass insbesondere bei einer Ausbildung als Spritzgussteil ein Fixier- bzw. Verriegelungselement eine erhöhte Dicke des Wandbereichs mit einer entsprechenden Verstärkungswirkung ausbildet. Wenn nun über ein Fixer- bzw. Verriegelungselement eine Halte- bzw. Klemmkraft von dem Anschlussstecker in den Wandbereich eingebracht wird, wird durch das nicht beanspruchte Fixier- bzw. Verriegelungselement eine Versteifung und somit eine besonders gute Krafteinleitung der Halte- bzw. Klemmkräfte in den Anschlussbereich ermöglicht.

Die Erfindung betrifft auch eine Verbindungsanordnung zwischen einem erfindungsgemäßen elektrischen Gerät und einem Anschlußstecker, der dazu ausgebildet ist, mit einem innerhalb oder außerhalb des Wandbereichs des elektrischen Geräts angeordneten Fixier- bzw. Verriegelungselement zusammenzuwirken.

Zur Erzielung einer möglichst einfachen Montage des Anschlusssteckers an dem elektrischen Gerät kann es vorgesehen sein, dass der Anschlußstecker einen Klemmbügel aufweist. Ein derartiger Klemmbügel hat den Vorteil, dass über ihn dadurch seine Kraftübersetzung relativ hohe Klemm- bzw. Haltekräfte bei relativ geringen Bedienkräften erzeugt werden können, und dass der Klemmhebel üblicherweise eine definierte Endposition aufweist, die von einem Bediener besonders einfach erkannt werden kann.

Zur Erzielung einer möglichst hohen Dichtwirkung zwischen dem Anschlussbereich und dem Anschlussstecker ist es bei einer Weiterbildung der Verbindungsanordnung vorgesehen, dass der Anschlußstecker eine der Kontur des Wandbereichs angepasste, geschlossene Umfangswand aufweist, die innerhalb oder außerhalb des Wandbereichs der Aufnahmekontur mit dieser zumindest bereichsweise zusammenwirkt.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine perspektivische Ansicht eines als Kunststoffspritzgußteil ausgebildeten erfindungsgemäßen Steckerkörpers an einem elektrischen Gerät,
- Fig. 2: den Steckerkörper gemäß Fig. 1 in perspektivischer Einzeldarstellung,
- Fig. 3: eine vereinfachte Draufsicht auf einen gegenüber den Fig. 1 und 2 modifizierten Steckerkörper zur Verdeutlichung unterschiedlicher Verriegelungsoptionen,
- Fig. 4 und Fig. 5: den Steckerkörper gemäß Fig. 3 in Verbindung mit einem fahrzeugseitigen Anschlussstecker zur Ausbildung einer Außenverriegelung sowie einer Innenverriegelung, jeweils in vereinfachter Darstellung und
- Fig. 6 und Fig. 7: die Verbindungsanordnungen gemäß der Fig. 4 und 5 in jeweils perspektivischer, teilweise geschnittener Ansicht.

Gleiche Elemente bzw. Elemente mit gleicher Funktion sind in den Figuren mit den gleichen Bezugsziffern versehen.

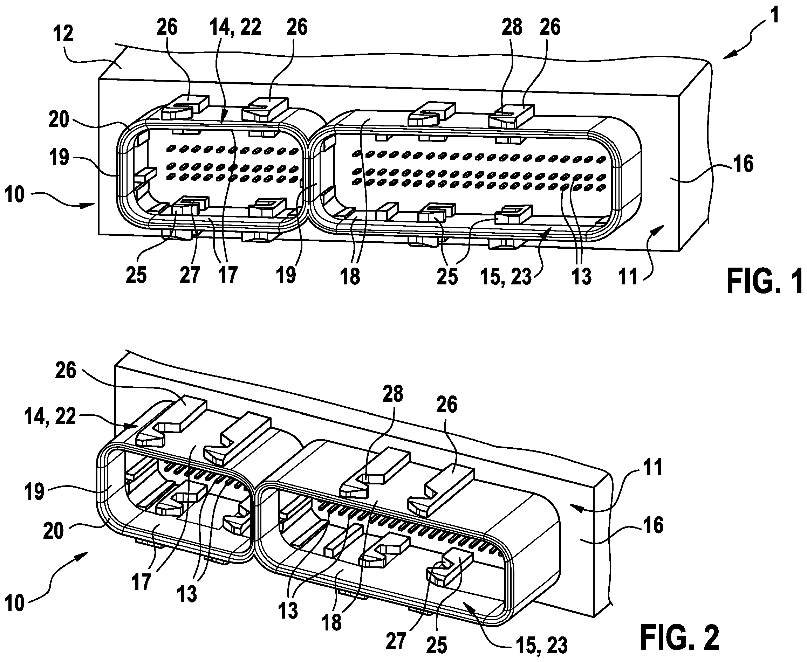

In den Fig. 1 und 2 ist ein Anschlussbereich 10 eines elektrischen Geräts 1, insbesondere eines Schalt- oder Steuergeräts in einem Kraftfahrzeug, dargestellt. Der Anschlussbereich 10 wird durch einen aus Kunststoff bestehenden und im Spritzgussverfahren hergestellten Steckerkörper 11 ausgebildet, der an einer Stirnseite eines lediglich in der Fig. 1 erkennbaren Gehäuses 12 des elektrischen Geräts 1 angeordnet bzw. mit dem Gehäuse 12 verbunden ist. Das Gehäuse 12 dient in bekannter Art und Weise der Aufnahme einer elektronischen bzw. elektrischen Schaltung, insbesondere auf wenigstens einem Schaltungsträger wie einer Leiterplatte o.ä., wobei die elektronische bzw. elektrische Schaltung über in den Fig. 1 und 2 erkennbare Anschlusspins 13 bzw. Steckerfahnen elektrisch kontaktierbar ist.

Bei dem in den Fig. 1 und 2 dargestellten Ausführungsbeispiel ist der Anschlussbereich 10 mit zwei, jeweils eine geschlossene, im Wesentlichen rechteckförmige Kontur aufweisenden Wandbereichen 14, 15 ausgestattet, die sich senkrecht von der Stirnseite 16 des Steckerkörpers 11 erstrecken bzw. von dieser wegragen und die Anschlusspins 13 umgeben. Die beiden Wandbereiche 14, 15 weisen jeweils zwei parallel zueinander angeordnete Wandabschnitte 17, 18 auf, wobei die Wandabschnitte 17 des Wandbereichs 14 eine geringere Länge bzw. Erstreckung aufweisen als die Wandabschnitte 18 des Wandbereichs 15. Die Wandabschnitte 17, 18 sind mit jeweils parallel zueinander angeordneten, und senkrecht zu den Wandabschnitten 17, 18 angeordneten Wandabschnitten 19 verbunden, wobei die Übergangsbereiche 20 zwischen den Wandabschnitten 17, 19 und 18, 19 jeweils gerundet ausgebildet sind.

Ein Anschlussbereich 10, dessen Steckerkörper 11 zwei umlaufende Wandbereiche 14, 15 aufweist, dient der elektrischen Kontaktierung des elektrischen Geräts 10 mittels zweier, separater, in den Fig. 1 und 2 nicht dargestellter Anschlussstecker. Die Anschlussstecker sind dabei insbesondere Bestandteil eines fahrzeugseitigen Kabelbaums.

Erfindungsgemäß ist es vorgesehen, dass im Bereich der Wandbereiche 14, 15, die jeweils eine Aufnahmekontur 22, 23 für den erwähnten Anschlußstecker ausbilden, innerhalb und außerhalb der Aufnahmekontur 22, 23 jeweils wenigstens ein Fixier- bzw. Verriegelungselement 25, 26 angeordnet ist. Im dargestellten Ausführungsbeispiel gemäß der Fig. 1 und 2 sind innerhalb der jeweiligen Aufnahmekontur 22, 23 jeweils an den Wandabschnitten 17, 18 zwei Fixier- bzw. Verriegelungselemente 25, und außerhalb der Aufnahmekontur 22, 23 ebenfalls jeweils zwei Fixier- bzw. Verriegelungselemente 26 angeordnet. Weiterhin sind die Fixier- bzw. Verriegelungselemente 25, 26 insofern unterschiedlich ausgebildet, als dass sich die (äußeren) Fixier- bzw. Verriegelungselemente 26 über die gesamte Höhe der Wandabschnitte 17, 18 erstrecken, während die Fixier- bzw. Verriegelungselemente 25 diesbezüglich eine geringere Erstreckung aufweisen.

Die Fixier- bzw. Verriegelungselemente 25, 26 sind einstückig an dem jeweiligen Wandabschnitt 17, 18 des Wandbereichs 14, 15 angeformt und jeweils fluchtend zueinander angeordnet, d.h. auf jeweils unmittelbar gegenüberliegenden Bereichen des jeweiligen Wandabschnitts 17, 18. Ferner weist jedes der Fixier- bzw. Verriegelungselemente 25, 26 eine Aussparung 27, 28 in Form einer Aufnahmenut auf, die zur Ausbildung einer klemm- bzw. kraftschlüssigen Verbindung mit dem kabelbaumseitigen Gegen- bzw. Anschlußstecker dient. Die innerhalb der jeweiligen Aufnahmekontur 22, 23 angeordneten Fixier- bzw. Verriegelungselemente 25 dienen der Ausbildung einer Innenverriegelung, während die außerhalb der jeweiligen Aufnahmekontur 22, 23 angeordneten Fixier- bzw. Verriegelungselemente 26 der Ausbildung einer Außenverriegelung dienen.

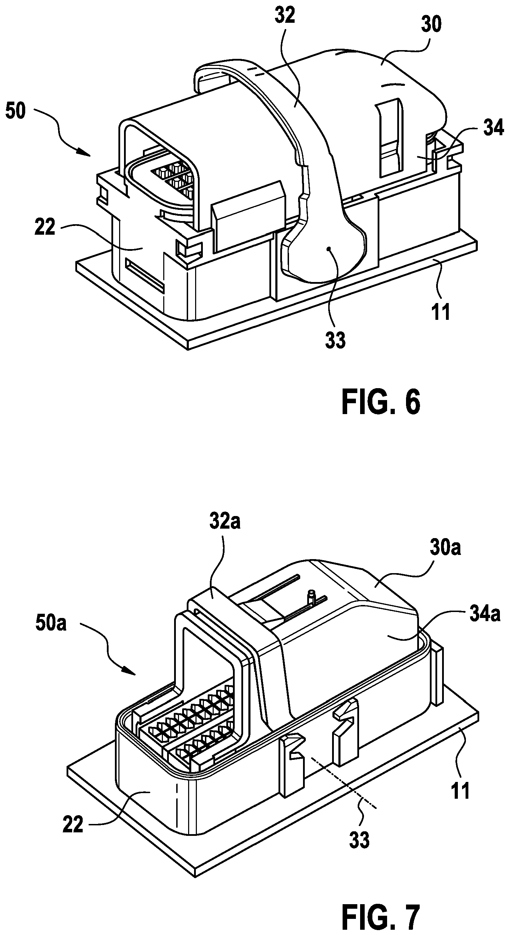

In den Fig. 6 und 7 ist jeweils in teilweise geschnittener Darstellung ein fahrzeugseitiger Gegen- bzw. Anschlußstecker 30, 30a zur Ausbildung einer Verbindungsanordnung 50, 50a zwischen dem Steckerkörper 11 des elektrischen Geräts 1 und dem entsprechenden Anschlußstecker 30, 30a dargestellt. Der in der Fig. 6 dargestellte Anschlußstecker 30 dient der Ausbildung einer Außenverriegelung, während der in der Fig. 7 dargestellte Gegenstecker 30, 30a dazu ausgebildet ist, mit dem Steckerkörper 11 eine Innenverriegelung auszubilden. In beiden Fällen weist der Anschlußstecker 30, 30a jeweils einen Klemmbügel 32, 32a auf, der um eine Achse 33 schwenkbar angeordnet ist, und in einer Endposition eine feste, verriegelte Verbindung zwischen dem jeweiligen Anschlußstecker 30, 30a und dem Anschlussbereich 10 bzw. dem Steckerkörper 11 ausbildet. Darüber hinaus sind beide Anschlußstecker 30, 30a mit einer geschlossenen Umfangswand 34, 34a versehen, die von der Aufnahmekontur 22 des Steckerkörpers 11 an deren Außenumfang (Fig. 6) bzw. am Innenumfang (Fig. 7), zumindest an einem Teilbereich derselben, im Wesentlichen spaltfrei umfasst ist.

Zur Ausbildung der Außenverriegelung weist der Anschlußstecker 30 an seinem Klemmhebel 32 Halteelemente (nicht dargestellt) auf, die mit den außerhalb der Aufnahmekontur 23 angeordneten Fixier- bzw. Verriegelungselementen 25 zusammenwirken. Der Anschlußstecker 30 weist daher im Bereich des Klemmhebels 32 eine größere Breite auf als die Aufnahmekontur 22 des Steckerkörpers 11.

Der in der Fig. 7 dargestellte Klemmhebel 32a ist demgegenüber innerhalb der Aufnahmekontur 22 des Steckerkörpers 11 angeordnet und weist ebenfalls Gegenelemente (nicht dargestellt) auf, die mit den innerhalb der Aufnahmekontur 22 angeordneten Fixier- bzw. Verriegelungselementen 26 zusammenwirken. Der Gegenstecker 30a verbreitert daher die Verbindungsanordnung 50a nicht über den Bereich der Aufnahmekontur 22 hinaus.

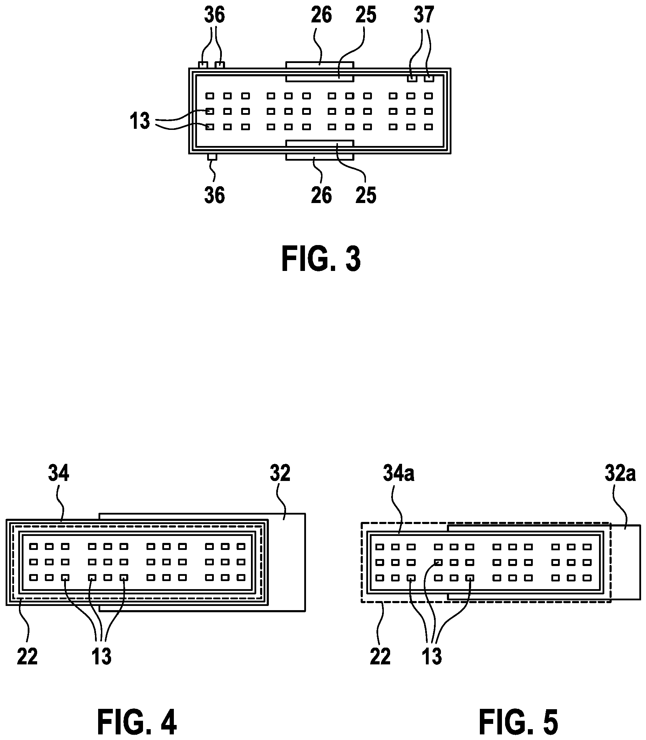

In den Fig. 3 bis 5 sind in vereinfachter Darstellung nochmals die Fixier- bzw. Verriegelungselemente 25, 26 am Steckerkörper 11 erkennbar. Darüber hinaus erkennt man anhand der Fig. 3 eine in Form von Vorsprüngen oder ähnliches ausgebildete, einstückig an dem Steckerkörper 11 angeformte Codierung 36, 37, die mit entsprechenden Gegencodierungen an dem Anschlußstecker 30, 30a zusammenwirken und insbesondere eine Verbindung des Anschlusssteckers 30, 30a mit dem Steckerkörper 11 nur in einer Richtung bzw. Orientierung ermöglichen.

In der Fig. 4 ist nochmals erkennbar, dass bei einer Außenverriegelung der Klemmhebel 32 die Aufnahmekontur 22 mit seiner Umfangswand 34 von außen her umfasst, während bei einer Innenverriegelung entsprechend der Darstellung der Fig. 5 der Klemmhebel 32a und die Umfangswand 34a innerhalb der Aufnahmekontur 22 angeordnet ist und daher die Breite der Aufnahmekontur 22 nicht vergrößert.

Das soweit beschriebene elektrische Gerät 1 sowie die Verbindungsanordnung 50 können in vielfältiger Art und Weise abgewandelt bzw. modifiziert werden, ohne vom Erfindungsgedanken abzuweichen. Dieser besteht in der Verwendung ein und desselben Steckerkörpers zur Verwendung bei einer Innenverriegelung oder einer Außenverriegelung in Zusammenwirkung mit einem entsprechend ausgebildeten Gegenstecker 30, 30a.

## Patentansprüche

1. Elektrisches Gerät (1), insbesondere Schalt- oder Steuergerät für ein Kraftfahrzeug, mit einem Gehäuse (12), das einen Anschlussbereich (10) zur elektrischen Kontaktierung des Gehäuses (12) mit einem Anschlußstecker (30; 30a) aufweist, wobei der Anschlussbereich (10) wenigstens eine, einen umlaufenden Wandbereich (14, 15) aufweisende Aufnahmekontur (22, 23) für den Anschlußstecker (30; 30a) umfasst, wobei der Wandbereich (14, 15) elektrische Anschlusselemente (13) umgibt, und wobei im Anschlussbereich (10) wenigstens ein Fixier- bzw. Verriegelungselement (25, 26) vorgesehen ist, das dazu ausgebildet sind, den Anschlußstecker (30; 30a) mit dem Gehäuse (12) im Anschlussbereich (10) zu verbinden, wobei jeweils wenigstens ein Fixier- bzw. Verriegelungselement (25, 26) sowohl innerhalb als auch außerhalb des Wandbereichs (14, 15) angeordnet ist zur wahlweisen Kontaktierbarkeit unterschiedlicher Anschlussstecker mit dem Anschlussbereich, welche entweder zur Ausbildung einer Innenverriegelung oder der Ausbildung einer Außenverriegelung im Zusammenwirken mit dem mindestens einen innen bzw. außen angeordneten Fixier- bzw. Verriegelungselement (25, 26) ausgebildet sind.

2. Elektrisches Gerät nach Anspruch 1,
**dadurch gekennzeichnet,**
**dass** das wenigstens eine Fixier- bzw. Verriegelungselement (25, 26) unmittelbar an dem Wandbereich (14, 15) befestigt ist.

3. Elektrisches Gerät nach Anspruch 2,
**dadurch gekennzeichnet,**
**dass** das wenigstens eine Fixier- bzw. Verriegelungselement (25, 26) an dem Wandbereich (14, 15) einstückig angeformt ist.

4. Elektrisches Gerät nach einem der Ansprüche 1 bis 3,
**dadurch gekennzeichnet,**
**dass** die Aufnahmekontur (22, 23) im Wesentlichen rechteckförmig ausgebildet ist, dass der Wandbereich (14, 15) wenigstens zwei zueinander parallele Wandabschnitte (17, 18) aufweist, und dass an jedem der beiden parallelen Wandabschnitte (17, 18) jeweils wenigstens ein Fixier- bzw. Verriegelungselement (25, 26) angeordnet ist.

5. Elektrisches Gerät nach einem der Ansprüche 1 bis 4,
**dadurch gekennzeichnet,**
**dass** das jeweils wenigstens eine Fixier- bzw. Verriegelungselement (25, 26) innerhalb und außerhalb des Wandbereichs (14, 15) unterschiedlich ausgebildet ist.

6. Elektrisches Gerät nach einem der Ansprüche 1 bis 5,
**dadurch gekennzeichnet,**
**dass** das wenigstens eine Fixier- bzw. Verriegelungselement (25, 26) eine Aussparung (27, 28) zur formschlüssigen Aufnahme eines Gegenelements des Anschlusssteckers (30; 30a) aufweist.

7. Elektrisches Gerät nach einem der Ansprüche 1 bis 6,
**dadurch gekennzeichnet,**
**dass** das jeweils wenigstens eine Fixier- bzw. Verriegelungselement (25, 26) innerhalb und außerhalb des Wandbereichs (14, 15) auf unmittelbar gegenüberliegenden Bereichen des Wandbereichs (14, 15) angeordnet ist.

8. Verbindungsanordnung (50; 50a), umfassend ein elektrisches Gerät (10) nach einem der Ansprüche 1 bis 7, und umfassend einen Anschlußstecker (30; 30a), der dazu ausgebildet ist, mit einem innerhalb oder außerhalb des Wandbereichs (14, 15) des elektrischen Geräts (1) angeordneten Fixier- bzw. Verriegelungselement (25, 26) zusammenzuwirken.

9. Verbindungsanordnung nach Anspruch 8,
**dadurch gekennzeichnet,**
**dass** der Anschlußstecker (30; 30a) einen Klemmbügel (32; 32a) zur kraft-Verbindung mit dem elektrischen Gerät (1) aufweist.

10. Verbindungsanordnung nach Anspruch 8 oder 9,
**dadurch gekennzeichnet,**
**dass** der Anschlußstecker (30; 30a) eine der Kontur des Wandbereichs (14, 15) angepasste, geschlossene Umfangswand (34; 34a) aufweist, die innerhalb oder außerhalb des Wandbereichs (14, 15) der Aufnahmekontur (22, 23) mit dieser zumindest bereichsweise zusammenwirkt.

## Claims

1. Electrical device (1), in particular switching or control device for a motor vehicle, comprising a housing (12) which has a connection region (10) for electrically contact-connecting the housing (12) to a connection plug (30; 30a), wherein the connection region (10) comprises at least one receiving contour (22, 23) for the connection plug (30; 30a), which receiving contour has an encircling wall region (14, 15), wherein the wall region (14, 15) surrounds electrical connection elements (13), and wherein at least one fixing or locking element (25, 26) is provided in the connection region (10), which fixing or locking element is designed to connect the connection plug (30; 30a) to the housing (12) in the connection region (10), wherein in each case at least one fixing or locking element (25, 26) is arranged both inside and outside the wall region (14, 15) for selectively being able to contact-connect different connection plugs to the connection region, which connection plugs are formed either for forming an internal locking arrangement or forming an external locking arrangement in interaction with the at least one fixing or locking element (25, 26) which is arranged on the inside or outside.

2. Electrical device according to Claim 1,
**characterized**
**in that** the at least one fixing or locking element (25, 26) is fastened directly to the wall region (14, 15).

3. Electrical device according to Claim 2,
**characterized**
**in that** the at least one fixing or locking element (25, 26) is integrally formed on the wall region (14, 15).

4. Electrical device according to one of Claims 1 to 3,
**characterized**
**in that** the receiving contour (22, 23) is of substantially rectangular design, in that the wall region (14, 15) has at least two wall sections (17, 18) which are parallel in relation to one another, and in that in each case at least one fixing or locking element (25, 26) is arranged on each of the two parallel wall sections (17, 18).

5. Electrical device according to one of Claims 1 to 4,
**characterized**
**in that** the in each case at least one fixing or locking element (25, 26) is designed differently inside and outside the wall region (14, 15).

6. Electrical device according to one of Claims 1 to 5,
**characterized**
**in that** the at least one fixing or locking element (25, 26) has a cutout (27, 28) for receiving a mating element of the connection plug (30; 30a) in an interlocking manner.

7. Electrical device according to one of Claims 1 to 6,
**characterized**
**in that** the in each case at least one fixing or locking element (25, 26) is arranged on indirectly opposite regions of the wall region (14, 15) inside and outside the wall region (14, 15).

8. Connecting arrangement (50; 50a) comprising an electrical device (10) according to one of Claims 1 to 7,
and comprising a connection plug (30; 30a) which is designed to interact with a fixing or locking element (25, 26) which is arranged inside or outside the wall region (14, 15) of the electrical device (1).

9. Connecting arrangement according to Claim 8,
**characterized**
**in that** the connection plug (30; 30a) has a clamping bracket (32; 32a) for force-fitting connection to the electrical device (1).

10. Connecting arrangement according to Claim 8 or 9,
**characterized**
**in that** the connection plug (30; 30a) has a closed circumferential wall (34; 34a) which is matched to the contour of the wall region (14, 15) and, inside or outside the wall region (14, 15) of the receiving contour (22, 23), interacts with this receiving contour at least in regions.

## Revendications

1. Appareil électrique (1), notamment appareil de commutation ou de commande pour un véhicule automobile, comprenant un boîtier (12) qui possède une zone de raccordement (10) destinée à la mise en contact électrique du boîtier (12) avec une fiche de raccordement (30 ; 30a), la zone de raccordement (10) comportant au moins un contour d'accueil (22, 23), possédant une zone de paroi (14, 15) périphérique, pour la fiche de raccordement (30 ; 30a), la zone de paroi (14, 15) entourant des éléments de raccordement (13) électriques, et au moins un élément de blocage ou de verrouillage (25, 26) se trouvant dans la zone de raccordement (10), lequel est configuré pour relier la fiche de raccordement (30 ; 30a) avec le boîtier (12) dans la zone de raccordement (10), au moins un élément de blocage ou de verrouillage (25, 26) étant respectivement disposé aussi bien à l'intérieur qu'à l'extérieur de la zone de paroi (14, 15) en vue d'une aptitude d'établissement de contact sélective de différentes fiches de raccordement avec la zone de raccordement, lesquelles sont configurées soit pour former un verrouillage intérieur, soit pour former un verrouillage extérieur en coopération avec l'au moins un élément de blocage ou de verrouillage (25, 26) disposé à l'intérieur ou à l'extérieur.

2. Appareil électrique selon la revendication 1, **caractérisé en ce que** l'au moins un élément de blocage ou de verrouillage (25, 26) est fixé directement à la zone de paroi (14, 15).

3. Appareil électrique selon la revendication 2, **caractérisé en ce que** l'au moins un élément de blocage ou de verrouillage (25, 26) est façonné d'un seul tenant à la zone de paroi (14, 15).

4. Appareil électrique selon l'une des revendications 1 à 3, **caractérisé en ce que** le contour d'accueil (22, 23) est de configuration sensiblement rectangulaire, **en ce que** la zone de paroi (14, 15) possède au moins deux portions de paroi (17, 18) parallèles l'une à l'autre, et **en ce qu'**au moins un élément de blocage ou de verrouillage (25, 26) est respectivement disposé au niveau de chacune des deux portions de paroi (17, 18) parallèles.

5. Appareil électrique selon l'une des revendications 1 à 4, **caractérisé en ce que** l'au moins un élément de blocage ou de verrouillage (25, 26) à l'intérieur et à l'extérieur de la zone de paroi (14, 15) est respectivement configuré différemment.

6. Appareil électrique selon l'une des revendications 1 à 5, **caractérisé en ce que** l'au moins un élément de blocage ou de verrouillage (25, 26) possède un évidement (27, 28) destiné à accueillir avec complémentarité de formes un élément homologue de la fiche de raccordement (30 ; 30a).

7. Appareil électrique selon l'une des revendications 1 à 6, **caractérisé en ce que** l'au moins un élément de blocage ou de verrouillage (25, 26) à l'intérieur et à l'extérieur de la zone de paroi (14, 15) est respectivement disposé sur des zones directement opposées de la zone de paroi (14, 15).

8. Arrangement de liaison (50 ; 50a), comprenant un appareil électrique (10) selon l'une des revendications 1 à 7 et comprenant une fiche de raccordement (30 ; 30a) qui est configurée pour coopérer avec un élément de blocage ou de verrouillage (25, 26) disposé à l'intérieur ou à l'extérieur de la zone de paroi (14, 15) de l'appareil électrique (1).

9. Arrangement de liaison selon la revendication 8, **caractérisé en ce que** la fiche de raccordement (30 ; 30a) possède un étrier de serrage (32 ; 32a) destiné à l'assemblage de force avec l'appareil électrique (1).

10. Arrangement de liaison selon la revendication 8 ou 9, **caractérisé en ce que** la fiche de raccordement (30 ; 30a) possède une paroi périphérique (34 ; 34a) fermée, adaptée au contour de la zone de paroi (14, 15), laquelle coopère avec le contour d'accueil (22, 23) au moins dans certaines zones à l'intérieur ou à l'extérieur de la zone de paroi (14, 15) de celui-ci.
